# FASCICULE DE BREVET EUROPEEN

(11) **EP 0 861 019 B1**
(45) Date de publication et mention de la délivrance du brevet: **14.07.2004**
(21) Numéro de dépôt: 98102286.6
(22) Date de dépôt: 10.02.1998
(51) Int. Cl.: H05K 5/00, F16J 15/06

(54) **Boîtier de protection pour circuit électronique**
Schutzgehäuse für eine Leiterplatte
Protecting housing for electronic circuit

(30) Priorité: 19.02.1997 FR 9701954
(43) Date de publication de la demande: 26.08.1998
(73) Titulaire: Siemens VDO Automotive S.A.S., 31036 Toulouse Cédex 01 (FR)
(72) Inventeur: Bergeret, Henri, 31820 Pibrac (FR)
(74) Mandataire: Berg, Peter, Dipl.-Ing.

(56) Documents cités:
- DE-A- 19 505 123
- PATENT ABSTRACTS OF JAPAN vol. 009, no. 179 (M-399), 24 juillet 1985 & JP 60 049166 A (ABO PACKING SEISAKUSHO:KK), 18 mars 1985,

## Description

La présente invention est relative à un boîtier de protection d'une carte de circuit électronique et, plus particulièrement, à un tel boîtier comprenant des moyens d'étanchement.

Des boîtiers de protection de ce type sont notamment utilisés dans l'industrie automobile où ils sont destinés à protéger un ou des circuits électroniques d'une contamination par des poussières qui se trouvent dans l'air ambiant ou par des fluides provenant du milieu extérieur. Dans l'environnement sévère que constitue notamment le compartiment moteur d'un véhicule automobile, on comprend qu'il est nécessaire de protéger efficacement tout calculateur électronique qui s'y trouve, pour commander un équipement de ce véhicule (moteur, dispositif d'antiblocage de roues, suspension active, etc...).

Un tel boitier comporte en général un fond dans lequel est inséré une carte de circuit électronique et un couvercle fixé sur le fond par vissage ou rivetage. Le circuit communique avec l'extérieur par des moyens de connexion électrique traversant le fond ou le couvercle. Pour contribuer à la protection de la carte vis-à-vis de rayonnements électromagnétiques extérieurs ou engendrés par la bobine d'allumage du véhicule, le boîtier est en général réalisé en métal et relié à la masse de ce véhicule.

Une manière usuelle de protéger la carte consiste à l'enrober totalement d'une résine ou d'un gel de protection coulé dans le boîtier. Cela présente l'inconvénient de ne pas permettre, une fois la carte installée dans son boîtier et noyée dans la résine, de la retirer et de pouvoir y effectuer des opérations de réparation. De plus, ces matériaux de protection sont onéreux.

Il est de même courant de rendre le boîtier étanche grâce à des joints d'étanchéité placés entre le fond et le couvercle et, éventuellement, entre une platine de support des moyens de connexion et l'élément (fond ou couvercle) du boitier qui porte cette platine. La mise en place de ces joints complique évidemment les opérations d'assemblage du fond du boitier avec la carte de circuit électronique et avec les moyens de connexion, ainsi que la mise en place du couvercle sur le fond; voir par example DE-A-195 05 123.

L'invention a donc pour but de remédier à ces inconvénients en fournissant un boîtier de protection du type précité qui soit, à la fois, parfaitement étanche, d'assemblage aisé et de fabrication peu coûteuse.

On atteint ce but de l'invention, ainsi que d'autres qui apparaîtront à la lecture de la description qui va suivre, avec un boîtier de protection pour carte de circuit électronique, du type comprenant un fond recevant la carte, un couvercle fermant le fond, des moyens installés dans une paroi latérale du fond pour établir une connexion électrique entre le circuit et l'extérieur du boîtier, et des moyens d'étanchement du boîtier. Suivant l'invention lesdits moyens d'étanchement comprennent des premier et deuxième joints en matériau élastique interposés respectivement entre les moyens de connexion et le fond du boîtier, et entre le fond et le couvercle, les deux joints étant raccordés, aux extrémités d'une longueur de joint commune située entre le couvercle et les moyens de connexion, par des portions de joint conformées en biseau, ces portions étant superposées deux à deux de manière à présenter une épaisseur globale constante.

Comme on le verra plus loin, ces caractéristiques des joints du boîtier suivant l'invention facilitent le montage de la carte de circuit électronique et de ses moyens de connexion dans le fond du boîtier, l'étanchéité du boîtier étant parfaitement assurée par lesdits joints, y compris au niveau des portions de joint taillées en biseau.

Avantageusement, l'épaisseur globale constante des portions de joint taillées en biseau et superposées est égale à celle du joint interposé entre le fond et le couvercle, ceci afin d'homogénéiser les efforts de compression sur les joints installés à ce niveau.

Suivant une autre caractéristique de l'invention, l'angle α du biseau desdites portions de joint est aigu.

Selon encore une caractéristique de l'invention, les deux joints sont réalisés en un même matériau élastique présentant des propriétés d'autocollage.

D'autres caractéristiques et avantages de la présente invention apparaîtront dans la description qui va suivre, donnée uniquement à titre d 'exemple et faite en se référant au dessin annexé dans lequel :
- la figure 1 représente une vue en perspective, éclatée, d'un boitier de protection selon l'invention,
- la figure 2 représente à plus grande échelle une vue partielle en coupe prise suivant le trait de coupe II-II de la figure 1.

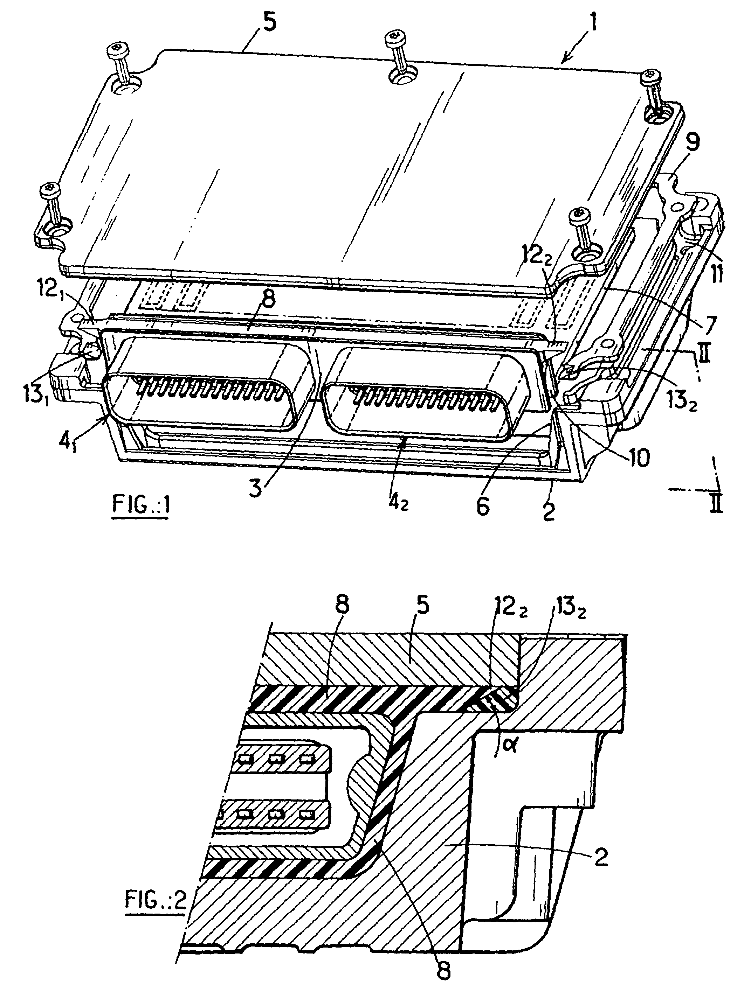

En se référant aux figures 1 et 2, il apparaît que le mode de réalisation représenté du boîtier de protection suivant l'invention 1 comprend un fond 2, des moyens de connexion 3, 4₁, 4₂, et un couvercle 5. Les moyens de connexion sont constitués, à titre d'exemple non limitatif, par deux connecteurs désignés 4₁, 4₂, à broches en ligne, montés sur une platine 3, les moyens 3,4₁,4₂ constituant un ensemble monobloc. Suivant l'invention, la platine 3 est conformée complémentairement à une découpe 6 d'une paroi latérale du fond 2, pour y être installée en complétant cette paroi latérale et en permettant aux moyens de connexion (3,4₁,4₂) d'assurer le raccordement d'une carte de circuit électronique 7 placée à l'intérieur du boitier 1, à des organes ou équipements extérieurs au boitier 1. Pour ce faire les broches des connecteurs 4₁ et 4₂ sont soudées classiquement à la carte 7, qui forme alors un tout avec les moyens de connexion (3,4₁,4₂).

Le fond 2 et le couvercle 5 s'adaptent complémentairement l'un à l'autre suivant un contour fermé de jonction proche du bord du couvercle 5. Celui-ci est fixé sur le fond 2 par tous moyens convenables, des vis par exemple.

Lors de l'assemblage du boîtier suivant l'invention, trois éléments séparés se présentent : le fond 2, le couvercle 5 et l'ensemble constitué par la carte 7 et les moyens de connexion (3, 4₁, 4₂) fixés sur cette carte. Bien entendu, pour assurer l'étanchéité du boîtier, il convient d'équiper ces éléments de moyens d'étanchement disposés au long de leurs surfaces d'assemblage.

Suivant la présente invention, ces moyens d'étanchement comprennent un premier joint 8 monté sur la platine 3 des moyens de connexion et un deuxième joint 9 monté sur le contour du débouché du fond 2 du boitier.

Le premier joint 8 prend la forme d'un bracelet en un matériau élastique logé dans une rainure 10 à contour fermé débouchant sur le pourtour de la platine 3. Le deuxième joint 9 est également en un matériau élastique et son contour prend généralement la forme d'un U conforme à trois bords contigus du couvercle 5 du boîtier. Ce dernier joint est logé dans une rainure 11 creusée dans les bords en regard du débouché du fond 2 du boitier.

Suivant une caractéristique de la présente invention, l'étanchéité de la jonction entre le fond 2 et le couvercle 5 est assurée, au long du quatrième bord du couvercle 5 qui fait face à la platine 3, par la longueur du joint 8 courant sur le bord de cette platine, en regard du couvercle 5. C'est ainsi que le premier joint 8 complète, en quelque sorte, le deuxième joint 9, par une longueur de joint "commun", encore que cette dernière soit entièrement comprise dans le joint 8 et montée sur la platine 3.

Il convient évidemment que le fond 2 du boitier et la platine 3 soient dessinés de manière que la longueur du joint 8 qui complète le joint 9 présente, après montage de la platine dans la découpe 6 du boîtier, une face extérieure coplanaire avec celle du joint 9 installé dans la rainure 11 du fond 2. C'est ainsi que lors de la fixation du couvercle 5 sur le fond 2, ce couvercle 5 s'applique étroitement sur les deux faces coplanaires du joint 9 et de ladite longueur de joint commun.

Les géométries des deux joints 8 et 9 décrites ci-dessus, et leur disposition dans deux plans sensiblement orthogonaux, facilitent l'assemblage et le démontage du boitier suivant l'invention. On comprend en effet que la forme en U du joint 9 dégage complètement l'accès de la découpe 6 du boîtier pour la platine 3 du support des connecteurs 4₁, 4₂. On peut alors installer simultanément, par un mouvement de direction perpendiculaire au fond du boîtier, la carte de circuit électronique 7 sur le fond du boîtier et la platine 3 dans la découpe 6 de ce boîtier. Il reste ensuite seulement à fixer le couvercle 5 pour terminer l'assemblage du boîtier.

La formation en deux parties des moyens d'étanchement appliqués contre le couvercle exige que la jonction des extrémités du joint 9 avec la longueur du joint 8 qui le complète au niveau du couvercle 5, soit parfaitement étanche.

Pour ce faire, des portions de joint 12₁, 12₂, conformées en biseau, débordent des extrémités de ladite longueur du joint 8 alors que les extrémités 13₁, 13₂ du joint 9 sont conformées en portions de joint complémentaires, également en biseau, de manière que les portions de joint en regard (12₁,13₁) et (12₂,13₂) qui se superposent lors du montage de la platine 3 sur le fond 2 garni du joint 9, reconstituent à leurs endroits un joint d'épaisseur constante.

Avantageusement, cette épaisseur constante est égale à celle des joints 8 et 9, au niveau du plan de jonction du fond 2 et du couvercle 5.

Avantageusement encore, ce matériau est le même pour les deux joints. On est assuré alors, après avoir fixé le couvercle 5, que la pression exercée par celui-ci sur les joints est uniforme, ce qui est favorable à l'étanchéité du boîtier.

Cette étanchéité est encore renforcée quand on choisit pour les joints un matériau susceptible d'autocollage car ainsi on est assuré de l'étanchéité des interfaces des portions des joints 12₁, 13₁ et 12₂, 13₂ respectivement, accolées aux deux extrémités du joint 9. On pourra choisir à cet égard un matériau élastomère de silicone dans lequel s'opèrent des migrations de molécules à travers de telles interfaces, favorables au collage des faces en regard.

On choisit avantageusement pour l'angle α du biseau des portions de joint 12₁,13₁,12₂,13₂, un angle très fermé, compris entre 5° environ et 35° environ, de préférence. Des irrégularités des surfaces en regard de ces portions, dues aux tolérances de fabrication par exemple, sont alors réparties sur des longueurs plus grandes de ces surfaces ce qui diminue leur influence sur la constance de l'épaisseur globale des joints, là où ces portions se superposent. Le choix d'un angle faible assure un recouvrement des joints sur une grande longueur de sorte que des défauts de positionnement d'un joint par rapport à l'autre n'entraînent pas de défauts d'étanchéité.

Il apparaît maintenant que l'invention permet bien d'atteindre les buts fixés, à savoir fournir un boitier parfaitement étanchéifié par des moyens peu coûteux et assemblables suivant une procédure simple qui réduit elle aussi son coût de fabrication. En outre, le boîtier n'est pas encombré par la matière de remplissage qui assurait auparavant l'étanchéité de tels boîtiers. Cela libère de la place pour des cartes électroniques et facilite le démontage de celles-ci.

Bien entendu, l'invention n'est pas limitée à son application en électronique automobile, décrite ci-dessus seulement à titre d'exemple, et s'entend au contraire à tout boîtier devant être installé dans un environnement susceptible de détériorer l'électronique qu'il contient.

## Revendications

1. Boîtier de protection pour carte de circuit électronique (7), du type comprenant un fond (2) recevant la carte (7), un couvercle (5) fermant le fond (2), des moyens (3, 4₁, 4₂) installés dans une paroi latérale du fond pour établir une connexion électrique entre le circuit et l'extérieur du boîtier, et des moyens d'étanchement du boitier, **caractérisé en ce que** lesdits moyens d'étanchement comprennent des premier (8) et deuxième joints (9) en matériau élastique interposés respectivement entre les moyens de connexion (3, 4₁, 4₂) et le fond (2) du boîtier, et entre le fond (2) et le couvercle (5), les deux joints (8,9) étant raccordés, aux extrémités d'une longueur de joint commun située entre le couvercle (5) et les moyens de connexion (3, 4₁, 4₂), par des portions de joint conformées en biseau (12₁, 13₁; 12₂, 13₂), ces portions étant superposées deux à deux de manière à présenter une épaisseur globale constante.

2. Boîtier de protection selon la revendication 1, **caractérisé en ce que** ladite épaisseur globale constante est égale à celle du joint (8) interposé entre le fond (2) et le couvercle (5).

3. Boîtier de protection selon la revendication 1 ou 2, **caractérisé en ce que** les plans des premier (8) et deuxième (9) joints sont sensiblement perpendiculaires.

4. Boîtier de protection selon l'une quelconque des revendications précédentes, **caractérisé en ce que** l'angle α de biseau desdites portions est un angle aigu.

5. Boîtier de protection selon la revendication 4, **caractérisé en ce que** ledit angle α de biseau est compris entre environ 5° et environ 35°.

6. Boîtier de protection selon l'une quelconque des revendications précédentes, **caractérisé en ce que** les deux joints (8, 9) sont réalisés en un même matériau élastique présentant des propriétés d'autocollage.

7. Boîtier de protection selon la revendication 6, **caractérisé en ce que** ledit matériau est un matériau élastomère de silicone.

8. Boîtier de protection selon l'une quelconque des revendications précédentes, protégeant un calculateur électronique de commande d'un équipement de véhicule automobile.

## Claims

1. Protective housing for an electronic circuit board (7), comprising a base (2) able to hold the circuit board (7), a cover (5) which closes the base (2), connectors (3, 41, 42) fitted in a side wall of the base for establishing an electrical connection between the circuit and the exterior of the housing, and means of sealing the housing, **characterized in that** the said means of sealing comprise a first (8) and a second (9) gasket made of a resilient material and interposed between the connectors (3, 41, 42) and the base (2) of the housing, and between the base (2) and the cover (5) respectively, the two gaskets (8 and 9) being joined at the ends of a common length of gasket positioned between the cover (5) and the connectors (3, 41, 42), by sections of chamfered gasket (121, 131; 122, 132), the said sections being superposed two by two in order to provide a constant overall thickness.

2. Protective housing according to claim 1, **characterized in that** the said constant overall thickness is equal to that of the gasket (8) interposed between the base (2) and the cover (5).

3. Protective housing according to claim 1 or 2, **characterized in that** the planes of the first (8) and second (9) gaskets are approximately perpendicular.

4. Protective housing according to any one of the preceding claims, **characterized in that** the angle α of chamfer of the said sections of gasket is an acute angle.

5. Protective housing according to claim 4, **characterized in that** the said angle α of chamfer is between approximately 5° and approximately 35°.

6. Protective housing according to any one of the preceding claims, **characterized in that** the two gaskets (8 and 9) are made of the same resilient material having self-adhesive properties.

7. Protective housing according to claim 6, **characterized in that** the said material is a silicone elastomer material.

8. Protective housing according to any one of the preceding claims, protecting an electronic command computer for a piece of equipment in a motor vehicle.

## Patentansprüche

1. Schutzgehäuse für eine Leiterplatte mit elektronischer Schaltung (7) vom Typ enthaltend ein Bodenstück (2) zum Aufnehmen der Platte (7), einen das Bodenstück (2) schließenden Deckel (5), in einer Seitenwand des Bodenstücks eingesetzte Mittel (3, 4₁, 4₂), zum Herstellen einer elektrischen Verbindung zwischen der Schaltung und dem Gehäuseäußeren, und Dichtungsmittel des Gehäuses, **dadurch gekennzeichnet, dass** die Dichtungsmittel eine erste (8) und eine zweite Dichtung (9) aus elastischem Material enthalten, die zwischen den Verbindungsmitteln (3, 4₁, 4₂) und dem Bodenstück (2) des Gehäuses bzw. zwischen dem Bodenstück (2) und dem Deckel (5) angeordnet sind, wobei die Dichtungen (8, 9) an den äußeren Enden einer gemeinsamen Dichtungslänge, die zwischen dem Deckel (5) und den Verbindungsmitteln (3, 4₁, 4₂) gelegen ist, durch mit Abschrägungen ausgebildete Dichtungsabschnitte (12₁, 13₁; 12₂, 13₂) verbunden sind, wobei diese Abschnitte paarweise derart übereinander liegen, dass sie eine konstante Gesamtdicke aufweisen.

2. Schutzgehäuse nach Anspruch 1, **dadurch gekennzeichnet, dass** die konstante Gesamtdicke gleich der Dicke der Dichtung (8) ist, die zwischen dem Bodenstück (2) und dem Deckel (5) angeordnet ist.

3. Schutzgehäuse nach Anspruch 1 oder 2, **dadurch gekennzeichnet, dass** die Ebenen der ersten (8) und der zweiten (9) Dichtung im wesentlichen senkrecht aufeinander stehen.

4. Schutzgehäuse nach einem der vorhergehenden Ansprüche, **dadurch gekennzeichnet, dass** der Winkel α der Abschrägung der Abschnitte ein spitzer Winkel ist.

5. Schutzgehäuse nach Anspruch 4, **dadurch gekennzeichnet, dass** der Winkel α der Abschrägung im Bereich zwischen ungefähr 5° und ungefähr 35° liegt.

6. Schutzgehäuse nach einem der vorhergehenden Ansprüche, **dadurch gekennzeichnet, dass** die beiden Dichtungen (8, 9) aus dem gleichen elastischen Material gebildet sind, welches selbstklebende Eigenschaften aufweist.

7. Schutzgehäuse nach Anspruch 6, **dadurch gekennzeichnet, dass** das Material ein Silikonelastomermaterial ist.

8. Schutzgehäuse nach einem der vorhergehenden Ansprüche, welches eine Rechenelektronik zur Steuerung einer Ausrüstung eines Kraftfahrzeuges schützt.
